# EUROPÄISCHE PATENTSCHRIFT

(11) **EP 0 756 447 B1**
(45) Veröffentlichungstag und Bekanntmachung des Hinweises auf die Patenterteilung: **21.10.1998**
(21) Anmeldenummer: 96117380.4
(22) Anmeldetag: 03.08.1994
(51) Int. Cl.: H05K 9/00

(54) **Schaltungsanordnung für Kraftfahrzeuge**
Control circuit for vehicle
Circuit de commande pour véhicule

(30) Priorität: 18.08.1993 DE 4327766
(43) Veröffentlichungstag der Anmeldung: 29.01.1997
(62) Teilanmeldung aus: 94112087.5
(73) Patentinhaber: Hella KG Hueck & Co., 59552 Lippstadt (DE)
(72) Erfinder: Klassen, Eugen, 59556 Lippstadt (DE); Raulf, Manfred, 59581 Warstein (DE); Rehberg, Helmut, 59555 Lippstadt (DE)

(56) Entgegenhaltungen:
- DE-U- 8 309 875
- US-A- 4 831 498
- US-A- 5 014 160

## Beschreibung

Die Erfindung betrifft eine Schaltungsanordnung für Kraftfahrzeuge, nach dem Oberbegriff des Anspruchs 1.

Derartige Schaltungsanordnungen werden zur Abschirmung Störpotential erzeugender oder Störpotential empfindlicher Bauteile von anderen Bauteilen und Schaltungsanordnungen verwendet, um Fehlfunktionen der Schaltungsanordnung aufgrund der Aussendung von Störpotential bzw. der Einstrahlung von Störpotential in Schaltungsanordnungen zu vermeiden. Bei den erzeugten Störpotentialen handelt es sich üblicherweise um elektromagnetische Hochfrequenzwellen, die zum Beispiel häufig von Mikrorechnerschaltungen erzeugt werden, die mit sehr hohen Taktfrequenzen bis zu 50 Megahertz arbeiten. Aufgrund der genannten hohen Taktfrequenzen, die zur Sicherstellung einer hohen Verarbeitungsgeschwindigkeit, insbesondere in Schaltungsanordnungen zur Motorsteuerung erforderlich sind, wird sowohl leitungsgebunden als auch leitungsungebunden Störpotential erzeugt, das andere Schaltungsanordnungen, wie zum Beispiel Rundfunkempfänger im Kraftfahrzeug, stören kann.

Eine Schaltungsanordnung nach dem Oberbegriff des Anspruchs 1 ist aus der DE-OS 40 00 286 vorbekannt. Diese vorbekannte Schaltungsanordnung zeigt ein Abschirmbehältnis für einen Bereich einer Leiterplatte, das aus einem Abschirmbehälterdeckel und aus einem Abschirmbehälterboden besteht. Die elektrische und mechanische Verbindung der Abschirmbehälterteile erfolgt dabei durch Ausnehmungen der Leiterplatte hindurch, wobei die Ausnehmungen als Durchkontaktierungen im Bereich zweier Leiterbahnringe ausgebildet sind, die Massepotential aufweisen.

Einer dieser Leiterbahnringe weist eine Unterbrechung zur Durchführung von Leiterbahnen auf, die die Störpotential erzeugenden oder empfindlichen Bauteile mit anderen Bauteilen elektrisch verbinden.

Eine weitere Schaltungsanordnung ist aus US-A-4 831 498 bekannt.

Die Erfindung hat die Aufgabe, eine Schaltungsanordnung für Kraftfahrzeuge zu schaffen, die einfach und kostengünstig herstellbar ist und bei gegebenen Störpotentialverhältnissen eine ausreichende Abschirmung des Störpotentials ermöglicht.

Diese Aufgabe wird durch die Kennzeichenmerkmale des Anspruchs 1 gelöst.

Beide Leiterbahnringe weisen Unterbrechungen auf, die gegeneinander axial versetzt sind.

Dadurch, daß beide Leiterbahnringe Unterbrechungen aufweisen, kann die Zahl der Leiterbahnen, die die Störpotential erzeugenden oder empfindlichen Bauteile mit anderen Bauteilen verbinden, wesentlich erhöht werden, ohne daß hierzu die erforderlichen Unterbrechungen nur eines Leiterbahnringes, wie aus dem Stand der Technik vorbekannt, besonders groß gewählt werden müßten. Mit diesen Maßnahmen kann die das Störpotential abschirmende Wirkung dieser Leiterbahnringe im Zusammenwirken mit den Abschirmbehälterteilen weitgehend vollständig aufrechterhalten werden.

Zur Verbesserung dieser Abschirmwirkung ist in diesem Zusammenhang erfindungsgemäß vorgesehen, daß die Unterbrechungen der beiden Leiterbahnringe gegeneinander axial versetzt angeordnet sind, so daß diese Unterbrechungen sich nicht auf den beiden Seiten der Trägerplatte gegenüberliegen. Durch diese Maßnahme wird ebenfalls vermieden, daß die erforderlichen Durchbrechungen oder Löcher des Abschirmbehältnisses eine Größe aufweisen müssen, die der elektromagnetischen Störstrahlung einen im wesentlichen ungehinderten Durchtritt ermöglicht. Zudem ist bei dieser erfindungsgemäßen Anordnung auch die beidseitige Bestückung der Trägerplatte mit Störpotential erzeugenden oder empfindlichen Bauteilen einfach möglich.

In diesem Zusammenhang können die Abschirmbehälterteile Lötkontaktfahnen aufweisen, die durch eine zweite Durchkontaktierung hindurchragen und mit den Leiterbahnringen verlötet sind. Mit diesen Maßnahmen wird sowohl die mechanische als auch die elektrische Verbindung der Abschirmbehälterteile mit den Leiterbahnringen gewährleistet. Dadurch weisen sowohl die Abschirmbehälterteile als auch die Leiterbahnringe dasselbe elektrische Potential auf.

Die erfindungsgemäße Lösung gemäß dem Anspruch 1 kann besonders vorteilhaft auch bei sogenannten Multilayerleiterplatten verwendet werden, bei denen die Trägerplatte mindestens vier leitfähige Schichten, Ebenen oder Lagen aufweist. In diesem Zusammenhang ist es besonders vorteilhaft, wenn eine durchgehende Masseebene und eine oder auch mehrere Versorgungsspannungsebenen vorgesehen sind, die innenliegend ausgebildet sind, so daß sie zwischen den Leiterschichten der Leiterbahnen auf beiden Außenseiten der Trägerplatte liegen.

In diesem Zusammenhang kann eine weitere positive Versorgungsspannungsebene durch eine ringförmige Freimachung von der anderen positiven Versorgungsspannungsebene getrennt werden. Dabei weist die eine innere Versorgungsspannungsebene mit den Abmessungen des Abschirmbehälters etwa entsprechende Außenabmessungen auf. Die elektrisch leitende Verbindung dieser inneren Versorgungsspannungsebene mit der sie umgebenden äußeren Versorgungsspannungsebene kann in diesem Zusammenhang besonders vorteilhaft direkt oder über eine andere Leiterschicht, nämlich über eine der beiden die Leiterbahnen tragenden Leiterschichten oder über die Masseebene erfolgen.

Um die Übermittlung leitungsgebundener Störpotentiale vom inneren der Leiterbahnringe zum äußeren der Leiterbahnringe und umgekehrt zu dämpfen, ist es bei allen erfindungsgemäßen Lösungen vorteilhaft, wenn Abblockkondensatoren vorgesehen sind, die die Leiterbahnen mit der Massefläche bzw. den üblicherweise Massepotential aufweisenden Leiterbahnringen verbinden. In diesem Zusammenhang können die Abblockkondensatoren besonders vorteilhaft innerhalb und außerhalb der Leiterbahnringe wechselweise angeordnet sein, um so bei vorgegebenen Außenabmessungen der Abblockkondensatoren die Dichte der Leiterbahnen im Bereich der Unterbrechungen erhöhen und damit deren Abstand entsprechend verringern zu können. Mit dieser Maßnahme kann nämlich die bei gegebener Zahl der Signalleiterbahn erforderliche Breite der Unterbrechung auf etwa die Hälfte reduziert werden, so daß die Abschirmwirkung weiter erhöht werden kann.

Wie vorher bereits mehrfach erwähnt ist es bei der erfindungsgemäßen Lösung besonders vorteilhaft, wenn der Leiterbahnring jeweils Massepotential aufweist, was sowohl die beanspruchte Beschaltung der Abblockkondensatoren ermöglicht als auch die Abschirmwirkung der Leiterbahnringe erhöht.

In der Masseebene können vorteilhaft Leiterbahnen isoliert eingelagert werden. Bei den eingelagerten Leiterbahnen kann es sich beispielsweise um die Verbindungsleitung zwischen den beiden positiven Versorgungsspannungsebenen handeln. Es kann sich auch um andere Leiterbahnen handeln, die zumindest teilweise außerhalb der Außenschichten der Trägerplatte geführt werden.

Ausführungsbeispiele der erfindungsgemäßen Schaltungsanordnung sind in den Zeichnungen dargestellt und werden im folgenden anhand der Zeichnungen näher erläutert.

Es zeigen
- Figur 1: eine Schaltungsanordnung mit zwei Leiterbahnringen, deren Unterbrechungen gegeneinander axial versetzt sind;
- Figur 2: die Schaltungsanordnung gemäß Figur 1 ergänzt um einen Abschirmbehälterdeckel und einen Abschirmbehälterboden;
- Figur 3: eine andere Ansicht der Schaltungsanordnung gemäß Figur 2;
- Figur 4: ein Detail der Schaltungsanordnung aus Figur 3;
- Figur 5: einen Leiterbahnring mit daran angeordneten Abblockkondensatoren;
- Figur 6: eine Ansicht auf den dem Leiterbahnring aus Figur 5 auf der Trägerplatte gegenüberliegenden Leiterbahnring mit Unterbrechung;
- Figur 7: den grundsätzlichen Aufbau einer Multilayerleiterplatte;
- Figur 8: eine Schaltungsanordnung mit einer Multilayerleiterplatte gemäß Figur 7,
- Figur 9: eine Leiterschicht der Multilayerleiterplatte gemäß Figur 7, die zwei positive Versorgungsspannungsebenen aufweist und
- Figur 10: eine Leiterschicht der Multilayerleiterplatte gemäß Figur 7, die zwei Masseebenen aufweist.

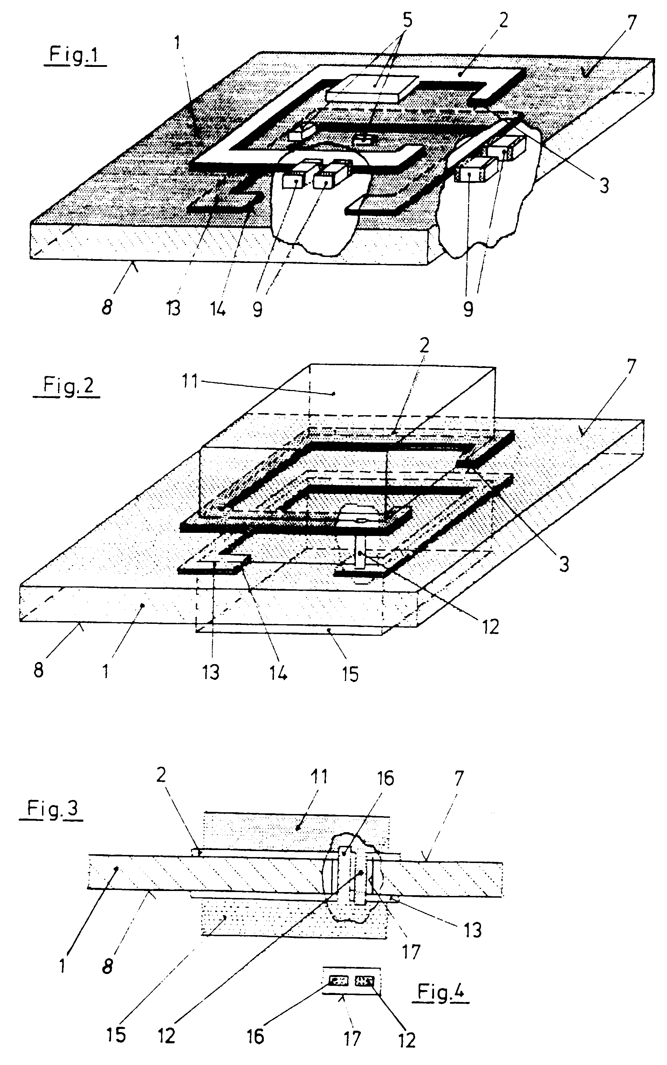

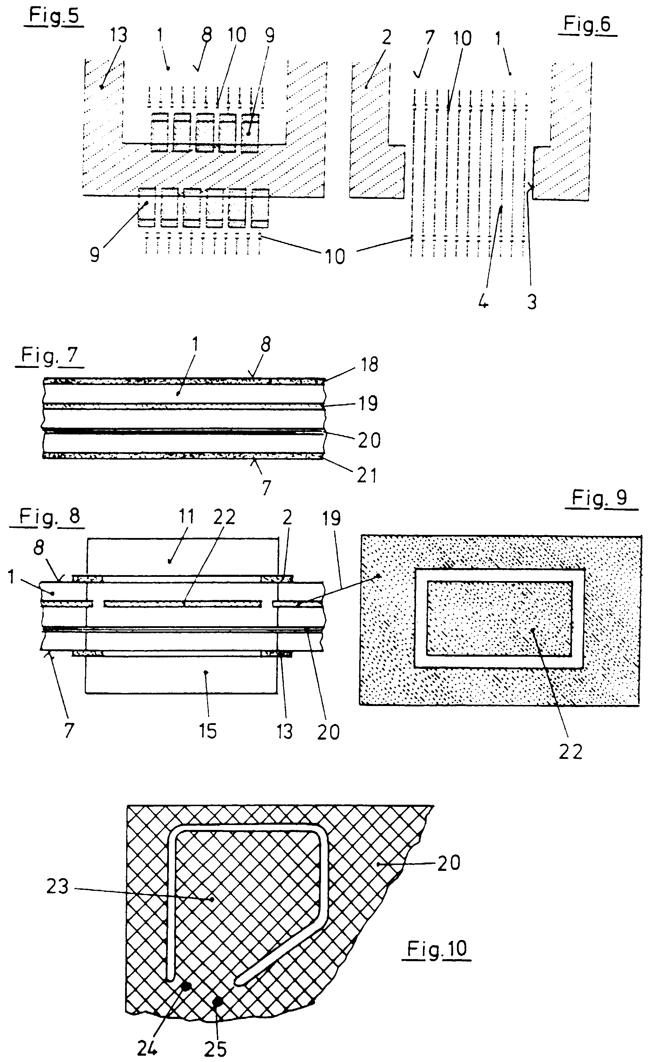

In der Figur 1 ist eine Leiterplatte (1) mit einem Massepotential aufweisenden Leiterbahnring (2) versehen, der im Bereich mehrerer Signalleiterbahnen (4) eine Unterbrechung (3) aufweist. Innerhalb des Leiterbahnringes (2) sind Störpotential erzeugende bzw. empfindliche Bauteile (5) angeordnet, die mittels der Signalleiterbahnen (4) gemäß Figur 6 mit weiteren Bauteilen außerhalb des Leiterbahnringes (2) elektrisch verbunden sind. Diese gesamte Anordnung befindet sich auf der Oberseite (7) der Trägerplatte (1).

Man erkennt hier eine Anordnung bei der auf beiden Seiten (7, 8) der Trägerplatte (1) Leiterbahnringe (2, 13) vorgesehen sind, die vorzugsweise Massepotential aufweisen. Auch der dortige zweite Leiterbahnring (13) weist eine zweite Unterbrechung (14) auf, durch die hindurch Signalleiterbahnen geführt werden, die in der Figur nicht dargestellt sind. Dabei ist die zweite Unterbrechung (14) gegenüber der ersten Unterbrechung (3) um einen Winkel von 90 Grad gegeneinander axial versetzt, um die sich gemeinsam mit der Dicke der Trägerplatte (1) ergebende Öffnung des Abschirmbehälters gemäß der später erläuterten Figur 2 so klein wie möglich zu halten. Es ist wesentlich vorteilhafter einen Abschirmbehälter mit mehreren kleinen Öffnungen als mit einer größeren Öffnung auszugestalten, weil der Durchtritt, insbesondere von hochfrequenten elektromagnetischen Wellen, stark von der Größe der Durchtrittsöffnung abhängig ist und mit größer werdenden Durchtrittsöffnungen drastisch zunimmt.

Weiterhin ist in der Figur 1 erkennbar, daß auf beiden Seiten (7, 8) der Trägerplatte (1) Abblockkondensatoren (9) vorgesehen sind, die jeweils mit den ihnen zugeordneten Leiterbahnringen (2, 13) im Sinne der Figuren 2 und 3 elektrisch leitend verbunden sind, um leitungsgebundene Störpotentiale zu dämpfen.

In der Figur 2 sind ebenfalls gleiche und gleichwirkende Einrichtungsteile wie in der Figur 1 mit den gleichen Bezugszeichen versehen. Man erkennt, daß ausgehend von einer Schaltungsanordnung gemäß der Figur 1 weiterhin ein Abschirmbehälterdeckel (11) und zusätzlich ein Abschirmbehälterboden (15) vorgesehen ist, das heißt, bei der erfindungsgemäßen Anordnung gemäß der Figur 2 wird der Abschirmbehälter durch den Abschirmbehälterdeckel (11), den Abschirmbehälterboden (15) und die unterbrochenen Leiterbahnringe (2, 13) gebildet. Diese Anordnung ermöglicht einerseits die Abschirmung auch energiereicher Störpotentiale, wie sie insbesondere bei hochfrequente betriebenen Mikrorechner-Schaltungsanordnungen auftreten.

Andererseits wird durch den vorgesehenen Abschirmbehälterboden auf der Unterseite (8) der Trägerplatte (1) ein zusätzlicher abgeschirmter Hohlraum geschaffen, in dem weitere hochfrequent bzw. Störpotential erzeugende bzw. empfindliche Bauteile (5) angeordnet werden können, um noch komplexere und damit Schaltungsanordnungen mit größerem Raumbedarf aufzubauen.

Die Figur 3, in der ebenfalls gleiche oder gleichwirkende Einrichtungsteile wie in den Figuren 1 bis 2 mit den gleichen Bezugszeichen versehen sind, wird in einer Seitenansicht deutlich, daß der Abschirmbehälterdeckel (11) eine erste Lötkontaktfahne (12) und der Abschirmbehälterboden (15) eine zweite Lötkontaktfahne (16) aufweist, die durch eine zweite, entsprechend breit ausgebildete Durchkontaktierungsöffnung (17) hindurchgesteckt sind. Die Abmessungen dieser zweiten Durchkontaktierung (17) werden auch in der Figur 4, die dieses Detail deutlicher darstellt, deutlich. Anschließend werden die Abschirmbehälterteile (11, 15) über ihre Lötkontaktfahnen (12, 16) mit den Leiterbahnringen (2, 13) derart, zum Beispiel in einem Schwallbad, verlötet, daß die Abschirmbehälterteile einerseits mechanisch fixiert und andererseits elektrisch leitend mit den Leiterbahnringen verbunden sind und insofern Massepotential aufweisen.

In der Figur 5 sind gleiche oder gleichwirkende Einrichtungsteile wie in den Figuren 1 bis 4 mit den gleichen Bezugszeichen versehen. Man erkennt in der Figur 5, daß die Abblockkondensatoren (9), die wiederum als SMD-Bauteile ausgebildet sind, innerhalb und außerhalb, in diesem Fall beispielweise des zweiten Leiterbahnringes (13), angeordnet sind. Die Anordnung erfolgt dabei zwischen den innerhalb und den außerhalb angeordneten Abblockkondensatoren (9) versetzt, so daß der Mittenabstand der Abblockkondensatoren (9) doppelt so groß sein kann, wie der Mittenabstand der Signalleiterbahnen (4) in der Figur 6, wie der dem in Figur 5 dargestellten zweiten Leiterbahnring (13) gegenüberliegenden Leiterbahnring (2) zeigt.

Auch in der Figur 6 sind gleiche oder gleichwirkende Einrichtungsteile wie in den Figuren 1 bis 5 mit denselben Bezugszeichen versehen. Die elektrische Verbindung des zweiten Leiterbahnringes (13) über die Abblockkondensatoren (9) mit den Signalleiterbahnen (4) erfolgt dabei durch die bereits vorher beschriebenen Durchkontaktierungen (10) in den Figuren 8 und 9. Durch die in den Figuren 5 und und 6 beschriebene Anordnung der Abblockkondensatoren (9) kann der Mittenabstand der Leiterbahnen (4) wie erläutert halb so groß gewählt werden wie der Mittenabstand der Abblockkondensatoren (9), so daß zur Durchführung der Leiterbahnen (4) durch die Unterbrechung (3) nur etwa der halbe Platz erforderlich ist und insofern die Unterbrechnung nur halb so breit sein muß, als wenn alle Abblockkondensatoren auf einer Seite des zweiten Leiterbahnringes (13) angeordnet wären. Dies erhöht die Abschirmwirkung der Leiterbahnringe (2, 13) zusätzlich.

In der Figur 7 ist die Trägerplatte (1) als Multilayerleiterplatte ausgebildet, die an ihren Außenseiten (7, 8) zwei Leiterschichten (18, 21) zur Ausbildung von Leiterbahnen (4) aufweist. Die innenliegenden Leiterschichten sind als positive Versorgungsspannungsebene (19) und als Masseebene (20) ausgebildet.

Bei Aufbau einer erfindungsgemäßen Schaltungsanordnung mit einer derartigen Multilayerleiterplatte gemäß Figur 7 gelangt man zu der in Figur 8 dargestellten Anordnung bei der gleiche oder gleichwirkende Einrichtungsteile wie in den Figuren 1 bis 7 mit den gleichen Bezugszeichen versehen sind.

Neben den Abschirmbehälterteilen (11, 15) und den Leiterbahnringen (2, 13) ist erkennbar, daß im Bereich des sich ergebenden Abschirmbehälters die Masseebene (20) durchgehend und möglichst ohne Unterbrechung ausgebildet ist. Demgegenüber weist die positive Versorgungsspannungsschicht gemäß Figur 9 eine erste den Abschirmbehälter in etwa umgebende positive Versorgungsspannungsebene (19) auf, von der durch eine ringförmige Freimachung eine zweite Versorgungspannungsebene (22) abgetrennt ist, deren Außenabmessungen in etwa den Außenabmessungen des Abschirmbehälters entsprechen. Bis auf die beschriebene ringförmige Freimachung sind die Versorgungsspannungsebenen (19, 22) bis auf notwendige Durchbrechungen ausgebildet.

Damit die zweite positive Versorgungsspannungsebene (22) dasselbe Potential aufweist wie die erste positive Versorgungsspannungsebene (19) ist eine Kontaktierung erforderlich. Diese Kontaktierung erfolgt, in den Figuren nicht dargestellt, durch zwei Durchkontaktierungen zu einer der beiden Leiterschichten (18, 21) oder der Masseebene (20) vorzugsweise zur Leiterschicht (18) auf der Unterseite (8) der Trägerplatte (1) hin und durch ein entsprechendes kurzes Leiterbahnstück auf dieser Leiterschicht (18). Das heißt, die erforderliche Kontaktierung wird nicht in der Ebene der Versorgungsspannungsebene (19, 22), sondern außerhalb dieser Ebene geführt. Versuche haben ergeben, daß auch diese konstruktive Lösung zur Abschirmung von Störpotential beiträgt.

Wird die leitende Verbindung der Ebenen (19, 22) über die Masseebene (20) hergestellt, so ist die zugehörige Leiterbahn, in den Figuren nicht dargestellt, in der Masseebene (20) isoliert einzulagern. Dies erbringt eine zusätzliche Minderung des Störpotentials durch Überkoppeln der Störung auf die Massefläche.

Entsprechend den zwei positiven Versorgungsspannungsebenen (19, 22) kann auch neben der Masseebene (20) eine zweite Masseebene (23) vorgesehen werden, die durch eine ringförmige Freimachung von der ersten Massenebene (20) getrennt und mit dem Abschirmbehälter (11, 15) etwa entsprechenden Abmessungen ausgebildet ist. Soll wie in der Figur 10 dargestellt die erforderliche leitende Verbindung zwischen den Masseebenen (20, 23) direkt erfolgen, so weist die zugehörige ringförmige Freimachung eine Unterbrechung auf, die diese leitende Verbindung bildet. Diese Lösung ist auch bei den Versorgungsspannungsebenen (19, 22) anwendbar. In diesem Fall kann die Massefläche (20) bzw. die zweite Massefläche (23) über die leitende Verbindung mit einem Anschluß eines Spannungsreglers (24) bzw. eines Massesteckers (25) großflächig leitend verbunden sein.

## Patentansprüche

1. Schaltungsanordnung für Kraftfahrzeuge mit einer elektrisch isolierenden Trägerplatte (1), mit auf der Trägerplatte (1) angeordneten, Störpotential erzeugenden oder empfindlichen Bauteilen (5), mit auf der Trägerplatte (1) angeordneten Leiterbahnen (4), die die Bauteile (5) mit anderen Bauteilen elektrisch verbinden, wobei die Bauteile (5) von zwei auf gegenüberliegenden Seiten der Trägerplatte (1) angeordneten Leiterbahnringen (2, 13) umgeben sind, von denen einer der Leiterbahnringe im Bereich der Leiterbahnen (4) eine Unterbrechung (3) aufweist, mit einem Abschirmbehälterdeckel (11), der die Bauteile (5) umgibt und mit einem Abschirmbhälterboden (15), der die Bauteile (5) umgibt, dadurch gekennzeichnet, daß beide Leiterbahnringe (2, 13) Unterbrechungen (3, 14) aufweisen, die gegeneinander axial versetzt sind.

2. Schaltungsanordnung nach Anspruch 1, dadurch gekennzeichnet, daß die Abschirmbehälterteile (11, 15) Lötkontaktfahnen (12, 16) aufweisen, die durch eine zweite Durchkontaktierung (17) hindurchragen und mit den Leiterbahnringen (2, 13) verlötet sind.

3. Schaltungsanordnung nach Anspruch 1, dadurch gekennzeichnet, daß die Trägerplatte (1) mindestens vier leitfähige Lagen (18 - 21) aufweist und daß eine Masseebene (20) und eine positive Versorgungsspannungsebene (19) innenliegend ausgebildet sind.

4. Schaltungsanordnung nach Anspruch 3, dadurch gekennzeichnet, daß eine weitere positive Versorgungsspannungsebene (22) durch eine ringförmige Freimachung von der anderen positiven Versorgungsspannungsebene (19) getrennt und mit dem Abschirmbehälter (11, 15) etwa entsprechenden Abmessungen ausgebildet ist und daß die leitende Verbindung dieser Ebenen (19, 22) direkt oder über eine andere Leiterschicht (18, 20, 21) hergestellt ist.

5. Schaltungsanordnung nach Anspruch 1, dadurch gekennzeichnet, daß Abblockkondensatoren (9) vorgesehen sind, die die Leiterbahnen (4) mit den Leiterbahnringen (2, 13) verbinden.

6. Schaltungsanordnung nach Anspruch 5, dadurch gekennzeichnet, daß die Abblockkondensatoren (9) innerhalb und außerhalb der Leiterbahnringe (2, 13) wechselweise angeordnet sind.

7. Schaltungsanordnung nach Anspruch 1, dadurch gekennzeichnet, daß die Leiterbahnringe (2, 13) Massepotential aufweisen.

8. Schaltungsanordnung nach Anspruch 3, dadurch gekennzeichnet, daß in der Masseebene (20) Leiterbahnen isoliert eingelagert sind.

## Claims

1. A circuit arrangement for motor vehicles, having an electrically insulating backing plate (1), having components (5) disposed on the backing plate (1) which generate or which are sensitive to interference potential, having strip conductors (4) which are disposed on the backing plate (1) and which electrically connect the components (5) to other components, wherein the components (5) are surrounded by two strip conductor rings (2, 13) disposed on opposite sides of the backing plate (1), one of which conductor rings comprises a gap (3) in the region of the strip conductors (4), having a screening vessel cover (11) which surrounds the components (5), and having a screening vessel base (15) which surrounds the components (5), characterised in that the two strip conductor rings (2, 13) comprise gaps (3, 14) which are axially displaced in relation to each other.

2. A circuit arrangement according to claim 1, characterised in that the screening vessel parts (11, 15) comprise soldered contact lugs (12, 16), which protrude through a second feed-through (17) and are soldered to the strip conductor rings (2, 13).

3. A circuit arrangement according to claim 1, characterised in that the backing plate (1) comprises at least four conductive layers (18 - 21) and that an earthing plane (20) and a positive supply voltage plane (19) are constructed inside.

4. A circuit arrangement according to claim 3, characterised in that a further positive supply voltage plane (22) is separated from the other positive supply voltage plane (19) by a ring-shaped gap and is constructed with dimensions approximately corresponding to those of the screening vessel (11, 15), and that the conducting connection between these planes (19, 22) is formed directly or via another conductor layer (18, 20, 21).

5. A circuit arrangement according to claim 1, characterised in that blocking capacitors (9) are provided which connect the strip conductors (4) to the strip conductor rings (2, 13).

6. A circuit arrangement according to claim 5, characterised in that the blocking capacitors (9) are disposed alternately inside and outside of the strip conductor rings (2, 13).

7. A circuit arrangement according to claim 1, characterised in that the strip conductor rings (2, 13) are at earth potential.

8. A circuit arrangement according to claim 3, characterised in that strip conductors are embedded insulated in the earthing plane (20).

## Revendications

1. Agencement de circuit pour véhicules automobiles équipé d'une plaque support (1) électriquement isolante, de composants (5) disposés sur la plaque support (1), générant un potentiel parasite ou sensibles à celui-ci, de pistes conductrices (4) disposées sur la plaque support (1), qui relient électriquement les composants (5) à d'autres composants, les composants (5) étant entourés par deux bagues conductrices (2, 13) disposées sur des côtés en vis-à-vis de la plaque support (1), dont l'une des bagues conductrices présente à proximité des pistes conductrices (4) une interruption (3) d'un couvercle de boîtier de blindage (11), qui entoure les composants (5) et d'un fond de boîtier de blindage (15), qui entoure les composants (5), caractérisé en ce que les deux bagues conductrices (2, 13) présentent des interruptions (3, 14), qui sont décalées axialement l'une par rapport à l'autre.

2. Agencement de circuit selon la revendication 1, caractérisé en ce que les parties de boîtier de blindage (11, 15) présentent des tiges de contact de soudage (12, 16), qui pénètrent à travers un second contact de traversée (17) et sont soudées aux bagues conductrices (2, 13).

3. Aqencement de circuit selon la revendication 1, caractérisé en ce que la plaque support (1) présente au moins quatre couches conductrices (18-21) et en ce qu'un plan de masse (20) et un plan de tension d'alimentation positive (19) sont réalisés à l'intérieur.

4. Agencement de circuit selon la revendication 3, caractérisé en ce qu'un autre plan de tension d'alimentation positive (22) est séparé par un dégagement annulaire de l'autre plan de tension d'alimentation positive (19) et est réalisé selon des dimensions correspondant approximativement au boîtier de blindage (11, 15) et en ce que la liaison conductrice de ces plans (19, 22) est réalisée directement ou par l'intermédiaire d'une autre couche conductrice (18, 20, 21).

5. Agencement de circuit selon la revendication 1, caractérisé en ce que des condensateurs de blocage (9) sont prévus, qui relient les pistes conductrices (4) aux bagues conductrices (2, 13).

6. Agencement de circuit selon la revendication 5, caractérisé en ce que les condensateurs de blocage (9) sont disposés en alternance à l'intérieur et à l'extérieur des bagues conductrices (2, 13).

7. Agencement de circuit selon la revendication 1, caractérisé en ce que les bagues conductrices (2, 13) se trouvent au potentiel de la masse.

8. Agencement de circuit selon la revendication 3, caractérisé en ce que des pistes conductrices sont introduites de façon isolée dans le plan de masse (20).
